# EUROPEAN PATENT APPLICATION

(11) **EP 4 531 080 A1**
(43) Date of publication of application: **02.04.2025**
(21) Application number: 23201054.6
(22) Date of filing: 29.09.2023
(51) Int. Cl.: H01L 21/67, H01L 21/683, H01L 21/687

(54) **CARRIER FOR LASER DIE TRANSFER, WAFER ASSEMBLY, AND PICK AND PLACE APPARATUS COMPRISING THE SAME**

(71) Applicant: Nexperia B.V., 6534 AB Nijmegen (NL)
(72) Inventor: Stokkermans, Joep, Nijmegen (NL); Wesselingh, Jasper, Nijmegen (NL)
(74) Representative: Pjanovic, Ilija

(57) **Abstract**

The present disclosure relates to a carrier for laser die transfer of semiconductor dies and to a wafer and a pick-and-place apparatus comprising the same. The carrier comprises an optically transparent secondary support layer, an optically transparent primary support layer attached to the secondary support layer, said primary support layer comprising one or more regions of an optically transparent first material, and a dynamic release layer attached to the primary support layer, wherein the dynamic release layer contacts the one or more regions of a first material. The dynamic release layer is configured to be coupled to a plurality of semiconductor dies, and to release one or more semiconductor dies among said plurality of said semiconductor dies when a region of the dynamic release layer directly adjacent to said one or more semiconductor dies is illuminated using laser light. The secondary support layer has a material composition different from the first material for reducing a flow of heat away from the primary support layer during the laser die transfer process.

## Description

### FIELD

The present disclosure generally relates to a carrier for laser die transfer of semiconductor dies. The present disclosure further relates to a wafer assembly comprising such a carrier, and a pick-and-place apparatus comprising such a carrier.

### BACKGROUND

Carriers for laser die transfer of semiconductor dies, typically for use in a pick-and-place apparatus, are known in the art. In such an apparatus, a wafer comprising a plurality of semiconductor dies is provided on a carrier. The carrier includes a primary support layer for supporting the wafer. In conventional laser die transfer applications, the primary support layer is optically transparent, and the wafer is arranged on a dynamic release layer attached to the primary support layer. The dynamic release layer is configured to release one or more semiconductor dies among said plurality of said semiconductor dies when a region of the dynamic release layer directly adjacent to said one or more semiconductor dies is illuminated using a laser. In this manner, said one or more semiconductor dies can be released from a carrier to transfer them to a second stage of the pick-and-place apparatus at a predetermined position for further processing of the semiconductor dies.

For the dynamic release layer to release the semiconductor dies, sufficient energy must be provided thereto via the laser. A measure for the required energy may typically be expressed as `fluence', or the energy of the laser pulse divided by the area it is illuminating.

At least for the purpose of energy efficiency as well as cost-effectiveness, there is a need for improving (i.e., reducing) the fluence required for releasing the semiconductor dies from the dynamic release layer.

### SUMMARY

It is an object of the present disclosure to provide a carrier for laser die transfer in which the abovementioned problems do not occur, or hardly so.

According to an aspect of the present disclosure, a carrier for laser die transfer of semiconductor dies is provided. The carrier comprises an optically transparent secondary support layer, an optically transparent primary support layer attached to the secondary support layer, said primary support layer comprising one or more regions of an optically transparent first material, and a dynamic release layer attached to the primary support layer, wherein the dynamic release layer contacts the one or more regions of a first material. The dynamic release layer is configured to be coupled to a plurality of semiconductor dies, and to release one or more semiconductor dies among said plurality of said semiconductor dies when a region of the dynamic release layer directly adjacent to said one or more semiconductor dies is illuminated using laser light. The secondary support layer has a material composition different from the first material for reducing a flow of heat away from the primary support layer during the laser die transfer process.

The Applicant has found that conventional carriers for laser die transfer applications may have an associated disadvantage that the primary support layer may absorb heat and effectively act as a heatsink. When a laser is applied to the carrier, part of the energy that should have been absorbed by the dynamic release layer will instead flow into the primary support layer and away from the dynamic release layer. As a result, the fluence required to release the semiconductor die from the carrier may be significantly higher than the energy that is actually absorbed by the dynamic release layer.

In accordance with the present disclosure, the secondary support layer, having a different material composition compared to the primary support layer, is provided to prevent or at least mitigate a flow of heat away from the primary support layer during the laser die transfer process. The Applicant has found that, compared to conventional carriers which may use glass primary support layers, the use of a secondary support layer in accordance with the present disclosure can provide a more than ten times reduction in fluence required to activate the release process.

Moreover, in accordance with the present disclosure, key properties of the primary support layer can be maintained with the arrangement described above. For example, the structure can remain chemically similar to conventional 'glass' carriers, and the interface between the primary support layer and the dynamic release layer can still withstand sufficient temperature as is the case in conventional carriers.

The thermal diffusivity of the material composition can be at least 2 times smaller than the thermal diffusivity of the first material, preferably at least 5 times smaller, and more preferably at least 10 times smaller.

The secondary support layer may comprise a substrate layer. The substrate layer may be made from a second material different from the first material.

The carrier may further comprise an intermediate layer. The substrate layer may be connected to the primary support layer through the intermediate layer.

In a further embodiment, the intermediate layer may comprise an adhesive layer.

Alternatively, the intermediate layer may comprise a body made from the second material, said body comprising a plurality of cavities or recesses that either hold a gaseous medium or are filed with a third material different from the first material. For example, the body may be integrally connected to the substrate layer.

Alternatively, the intermediate layer may comprise a body made from the first material, said body comprising a plurality of cavities or recesses that hold a gaseous medium and/or are filed with a third material different from the first material. For example, the body may be integrally connected to the primary support layer.

The cavities or recesses can further aid in preventing or at least mitigating heat flow away from the dynamic release layer, thus reducing the fluence required for releasing the dies.

The primary support layer may be formed entirely by a single region of the first material.

Alternatively, the one or more regions of the primary support layer may comprise mutually separated regions of the first material that are arranged in a body of a material different from the first material, such as the second material. As a result, a thermal barrier can effectively be provided not only below the primary support layer but also adjacent to the primary support layer with respect to the dynamic release layer. In these cases, semiconductor dies may be configured to be provided on the dynamic release layer where said dynamic release layer is in contact with the mutually separated regions to allow sufficient heat resistance of the interface between the dynamic release layer and the primary support layer where this is required, and provide a thermal barrier functionality to the primary support layer in a remainder thereof, thereby both minimizing the use of the first material and the fluence required to release the semiconductor dies from the dynamic release layer in practice.

The dynamic release layer may comprise a contiguous layer that covers the one or more regions of the primary support layer. Such a configuration is easily manufacturable as the dynamic release layer pattern need not be positioned accurately. For example, the dynamic release layer may cover the primary support layer entirely.

The dynamic release layer may comprises a plurality of mutually separated regions, each region of the dynamic release layer directly contacting a respective region of the primary support layer. As a result, the amount of material required to form the dynamic release layer can be minimized, for example by only arranging the dynamic release layer in so far as required for attaching the semiconductor die thereto.

In the above, various components and layers of the carrier have been described in accordance with the present disclosure. These components and layers may have the following exemplary thicknesses and/or materials, though the present disclosure is not limited thereto.

The primary support layer may have a thickness in a range between 0.01 and 1 mm. Additionally or alternatively, the secondary support layer may have a thickness in a range between 0.01 and 0.1 mm. Additionally or alternatively, the dynamic release layer may have a thickness in a range between 1 and 100 µm. Additionally or alternatively, the body of the secondary support layer may have a thickness in a range between 0.01 and 0.1 mm. Additionally or alternatively, the mutually separated regions of the first material may have a thickness in a range between 0.01 and 0.1 mm.

The first material may comprise at least one of glass, e.g., quartz glass, BK7 (which is a type of borosilicate glass), or the like, ceramic or siloxane. Additionally or alternatively, the second material may comprise at least one of polyethylene terephthalate (PET), polyethylene naphthalate (PEN), polyimide (PI) and polyvinyl chloride (PVC). Additionally or alternatively, the dynamic release layer may be made of at least one of molybdenum, aluminum, tin and indium. Additionally or alternatively, the adhesive layer may be made of at least one of epoxy, acrylic and benzocyclobutene. Additionally or alternatively, the third material may comprise at least one of aerogel and siloxane.

According to another aspect of the present disclosure, a wafer assembly is provided. The wafer assembly comprises the carrier according to any of the embodiments described above, and a wafer comprising a plurality of mutually separated semiconductor dies. The wafer is arranged on the carrier.

According to yet another aspect of the present disclosure, a pick-and-place apparatus is provided. The apparatus comprises a first stage comprising a carrier according to any of the embodiments described above, a laser source for illuminating the carrier, and a second stage configured to receive one or more semiconductor dies from the first stage when the carrier is illuminated using the laser source.

### DETAILED DESCRIPTION

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
FIG. 1 is a cross-sectional view of a carrier in accordance with an embodiment of the present disclosure;
FIG. 2 is a cross-sectional view of a wafer assembly in accordance with an embodiment of the present disclosure;
FIG. 3 is a cross-sectional view of a carrier in accordance with an embodiment of the present disclosure;
FIG. 4 is a cross-sectional view of a carrier in accordance with an embodiment of the present disclosure;
FIG. 5 is a cross-sectional view of a carrier in accordance with an embodiment of the present disclosure;
FIG. 6 is a cross-sectional view of a carrier in accordance with an embodiment of the present disclosure;
FIG. 7 is a schematic diagram of a pick-and-place apparatus in accordance with an embodiment of the present disclosure; and
FIG. 8 is a schematic diagram of a pick-and-place apparatus in accordance with an embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

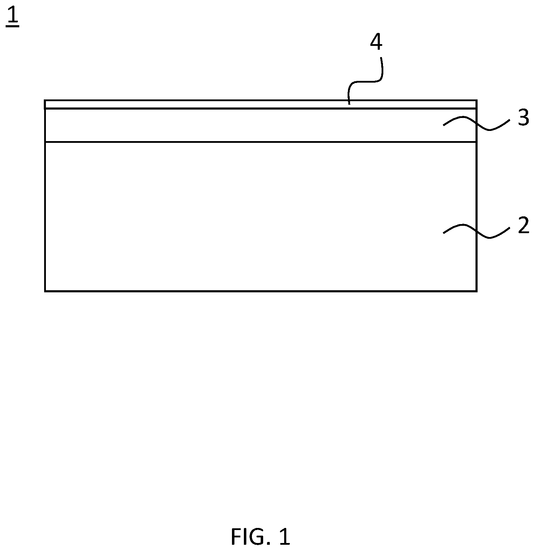

In FIG. 1, a carrier 1 in accordance with an embodiment of the present disclosure is shown. Here, carrier 1 comprises a secondary support layer 2, a primary support layer 3, and a dynamic release layer 4. Primary support layer 3 includes one or more regions of an optically transparent first material, such as glass, e.g., quartz glass or BK7. In this embodiment, primary support layer 3 is made entirely from said optically transparent first material.

Secondary support layer 2 is also optically transparent, but is made from a different material or material composition that provides the functionality of reducing a flow of heat away from the primary support layer during the laser die transfer process. For example, secondary support layer 2 includes a substrate layer made of a second material different from the first material. The second material may for example include PET, PEN, or the like.

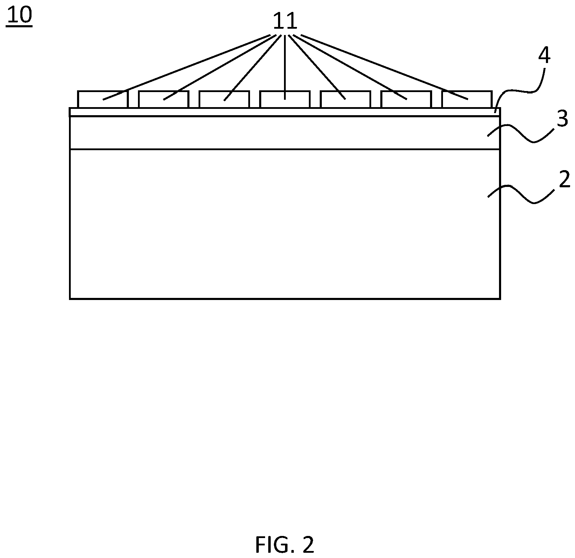

In FIG. 2, a wafer assembly 10 is shown in accordance with an embodiment of the present disclosure. In particular, FIG. 2 illustrates wafer assembly 10 comprising carrier 1 of FIG. 1.

Wafer assembly 10 comprises a wafer, including a plurality of semiconductor dies 11, that is arranged on carrier 1. In particular, semiconductor dies 11 are arranged on dynamic release layer 4. Here, dynamic release layer 4 is configured to be coupled to semiconductor dies 11, and to release one or more of said semiconductor dies 11 when a region of dynamic release layer 4 directly adjacent to said one or more semiconductor dies 11 is illuminated using laser light. Due to secondary support layer 2, the amount of fluence required to release semiconductor dies 11 from dynamic release layer 4 can be relatively low in practice compared to conventional carriers, resulting in a more energy-efficient and cost-effective solution.

In an example, semiconductor dies 11 are arranged on carrier 1 in a row, or in a matrix of rows and columns. Furthermore, semiconductor dies 11 may be mutually spaced apart at fixed, preferably identical distance intervals, though the present disclosure is not limited thereto.

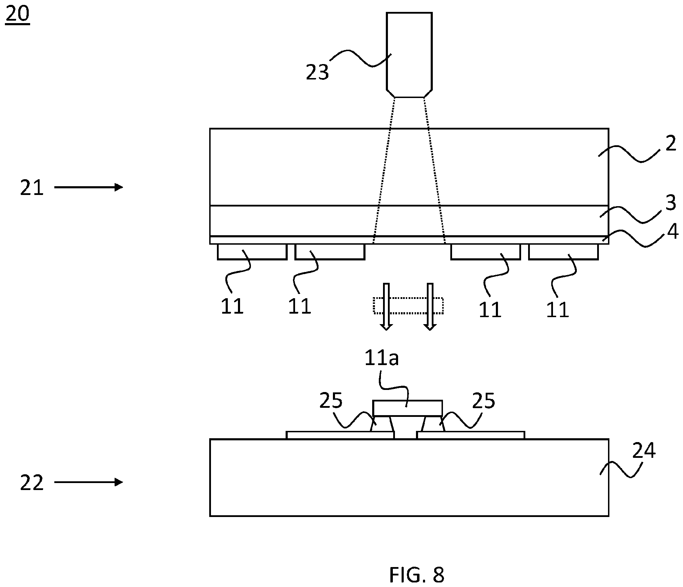

Although carrier 1 and wafer assembly 10 are illustrated as planar in FIG. 1 and FIG. 2, respectively, this need not be the case. As will be appreciated by the skilled person, carrier 1, and consequently also wafer assembly 10, may instead be formed such that wafer assembly 10 is circumferentially arranged along an outer surface of a rotatable drum. The drum can then be rotated to change a position of semiconductor dies 11 relative to an external element, such as a second stage of a pick-and-place apparatus, which apparatus is described in more detail with reference to FIG. 8.

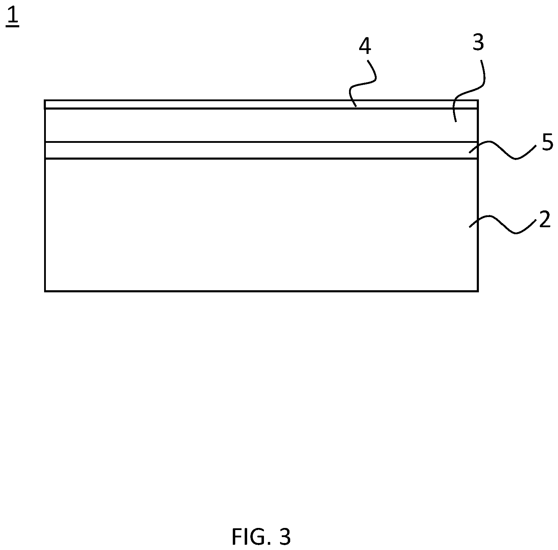

In the ensuing description below, reference will be made to carrier 1 in accordance with the present disclosure with reference to FIG. 3-7. As will be appreciated by the skilled person, each of the embodiments described below similarly relate to a wafer assembly in accordance with the present disclosure comprising said carrier 1 and a wafer including a plurality of semiconductor dies 11, for example as described above.

In FIG. 3, carrier 1 is shown in accordance with another embodiment of the present disclosure. This embodiment differs from the embodiment in FIG. 1 in that an intermediate layer 5 is provided. In this case, intermediate layer 5 may for example be an adhesive layer, such as epoxy, acrylic and benzocyclobutene. Intermediate layer 5 mutually fixes secondary support layer 2 and primary support layer 3 and can ensure sufficient rigidity and stability of carrier 1.

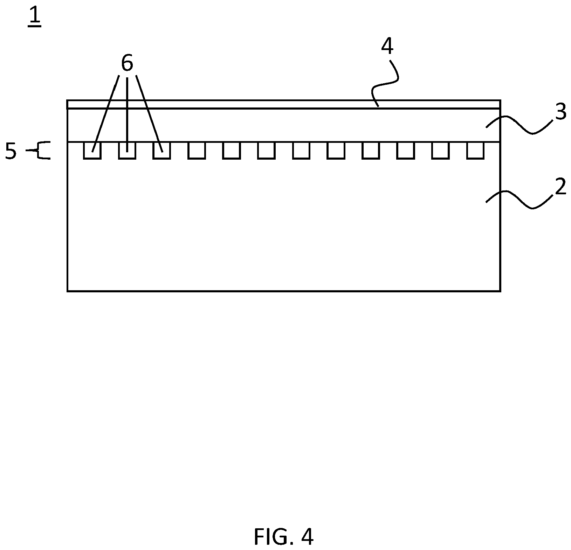

In FIG. 4, carrier 1 is shown in accordance with another embodiment of the present disclosure. Here, intermediate layer 5 is shown to include a body in which a plurality of recesses 6 are provided. These recesses or cavities 6 may hold or be filled with a gaseous medium and/or a third material different from the first material. For example, the third material may include aerogel.

The body of intermediate layer 5 may be made of the second material in this embodiment. In a preferred embodiment, intermediate layer 5 is integrally connected to secondary support layer 2, in which case the remainder of intermediate layer 5 not including recesses or cavities 6 is made of the second material. In the latter case, intermediate layer 5 can be easily manufactured by forming a plurality of cavities or recesses 6 at a side of secondary support layer 2, and optionally at least partially filling them with the third material or a gaseous medium. For example, the gaseous medium may include air or a vacuum.

Instead of recesses 6, cavities are equally envisaged. That is, instead of (or in addition to) recesses in an outer surface of the body, said body could comprise one or more cavities which the body surrounds. The cavities may then hold or be filled with the third material or a gaseous medium as explained above.

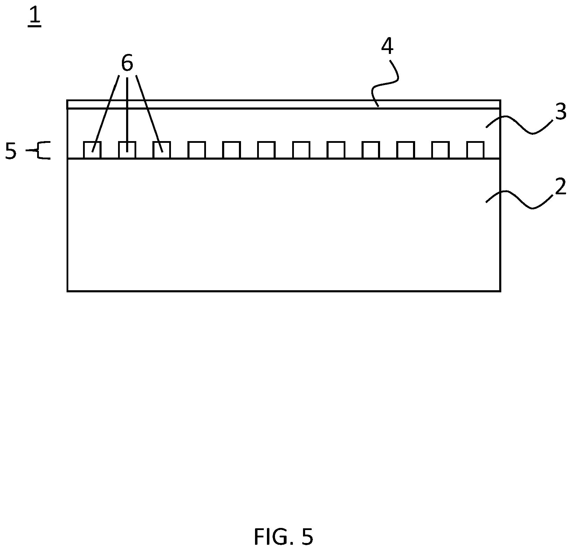

In FIG. 5, carrier 1 is shown in accordance with another embodiment of the present disclosure. Here, intermediate layer 5, not including cavities or recesses 6, may be made of the first material, and may be preferably integrally connected to primary support layer 3 as shown in FIG. 5. In the latter case, intermediate layer 5 can be easily manufactured by forming a plurality of cavities or recesses 6 at a side of primary support layer 3, and optionally at least partially filling them with the third material or a gaseous medium.

In the embodiment shown in FIG. 5, similarly to FIG. 4, cavities are equally envisaged instead of or in addition to recesses 6. That is, instead of (or in addition to) recesses in an outer surface of the body, said body could comprise one or more cavities which the body surrounds. The cavities may then hold or be filled with the third material or a gaseous medium as explained above.

In the embodiments shown in FIG. 4 and FIG. 5, recesses 6 (and/or cavities) may be formed to further prevent or at least mitigate thermal energy from flowing away from dynamic release layer 4.

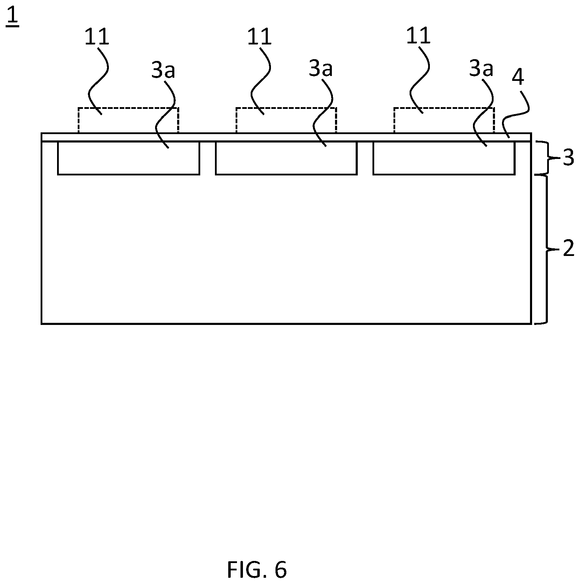

In the embodiments shown in FIG. 1-5, primary support layer 3 is illustrated as being formed entirely by a single region of the first material. However, the present disclosure is not limited thereto. Rather, primary support layer 3 may include more than one region of an optically transparent first material, and may optionally further include regions of a different material, as discussed below in more detail with reference to FIG. 6.

In FIG. 6, carrier 1 is shown in accordance with another embodiment of the present disclosure. Here, primary support layer 3 comprises a plurality of mutually separated regions 3a of first material arranged in a body of second material. In a preferred embodiment, said body of second material may be integrally formed with secondary support layer 2. Secondary support layer 2 and primary support layer 3 could then be manufactured by first providing a main body of second material, forming a plurality of recesses, and filling said recesses with first material to form regions 3a. Nevertheless, the present disclosure is not limited thereto.

As shown in FIG. 6, the wafer including semiconductor dies 11 can be arranged on carrier 1 such that semiconductor dies 11 are attached to dynamic release layer 4 adjacent to regions 3a of primary support layer 3. This allows preventing or at least mitigating heat flow away from dynamic release layer 4 without compromising the interface between dynamic release layer 4 and primary support layer 3 at positions where semiconductor dies 11 are configured to be arranged.

As will be appreciated by the skilled person, forming primary support layer 3 using one or more mutually separated regions 3a of the first material could be equally applied to any of the embodiments described with reference to FIG. 1-5.

In the above, embodiments are shown wherein dynamic release layer 4 is formed as a single contiguous layer that covers primary support layer 3. For example, dynamic release layer 4 may cover primary support layer 3 entirely. However, the present disclosure is not limited thereto.

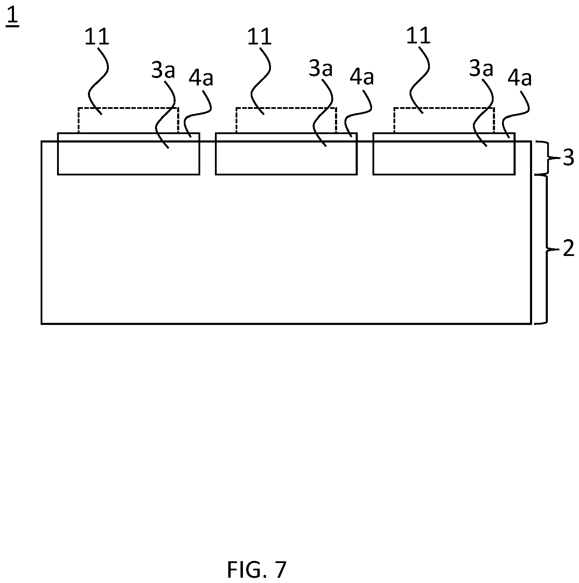

To illustrate this, in FIG. 7, carrier 1 is shown in accordance with another embodiment of the present disclosure, which differs from the embodiment in FIG. 6 in that dynamic release layer 4 comprises a plurality of mutually separated regions 4a, each being arranged adjacent to a respective region 3a of primary support layer 3. The wafer may for example be arranged on carrier 1 such that semiconductor dies 11 are attached to regions 4a of dynamic release layer 4 directly adjacent to regions 3a of primary support layer 3. In an example, dynamic release layer 4a may be patterned before, during, or after being arranged on primary support layer 3.

Similarly to FIG. 6, the embodiment of FIG. 7 allows preventing or at least mitigating heat flow away from dynamic release layer 4 without compromising the interface between dynamic release layer 4 and primary support layer 3 at positions where semiconductor dies 11 are configured to be arranged. In addition, the amount of material required for dynamic release layer 4 can be reduced. Moreover, regions 4a of dynamic release layer 4 can also be used for accurate positioning of semiconductor dies 11 to form wafer assembly 10.

As will be appreciated by the skilled person, although forming dynamic release layer 4 as a plurality of regions 4a is described with reference to FIG. 7, this concept may be identically or similarly applied to any of the embodiments described with reference to FIG. 1-6.

In FIG. 8, a pick-and-place apparatus 20 is shown in accordance with an embodiment of the present disclosure. Pick-and-place apparatus 20 comprises a first stage 21, formed by or including a wafer assembly (e.g., wafer assembly 10 of FIG. 2), a second stage 22, and a laser source 23.

Here, second stage 22 may represent a next stage on which the semiconductor die 11 is to be carried or processed further. For example, second stage 22 is shown to include a substrate 24 and a receiving element 25 configured to receive semiconductor die 11. This may already be an end stage of the process, i.e., substrate 24 may for example be a printed circuit board (PCB) on which semiconductor die 11 is to be mounted via receiving elements 25 (e.g., solder bumps). However, the present disclosure is not limited thereto.

In pick-and-place apparatus 20, second stage 22 is configured to receive semiconductor die 11a from first stage 21 when carrier 1 is illuminated using laser source 23. In particular, laser source 23 illuminates dynamic release layer 4 directly adjacent to semiconductor die 11a to activate the release function of dynamic release layer 4 and release semiconductor die 11 from first stage 21 to propagate it to second stage 22, as illustrated in FIG. 8 using arrows to indicate the direction of propagation of semiconductor die 11a. Since dynamic release layer 4 is only illuminated locally to release semiconductor die 11a specifically, remaining semiconductor dies 11 of the wafer can remain coupled to dynamic release layer 4.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims and, at least in some jurisdictions, their equivalents.

## Claims

1. A carrier for laser die transfer of semiconductor dies, comprising:
an optically transparent secondary support layer;
an optically transparent primary support layer attached to the secondary support layer, said primary support layer comprising one or more regions of an optically transparent first material; and
a dynamic release layer attached to the primary support layer, wherein the dynamic release layer contacts the one or more regions of a first material, the dynamic release layer being configured to be coupled to a plurality of semiconductor dies, and to release one or more semiconductor dies among said plurality of said semiconductor dies when a region of the dynamic release layer directly adjacent to said one or more semiconductor dies is illuminated using laser light,
wherein the secondary support layer has a material composition different from the first material for reducing a flow of heat away from the primary support layer during the laser die transfer process.

2. The carrier according to claim 1, wherein the thermal diffusivity of the material composition is at least 2 times smaller than the thermal diffusivity of the first material, preferably at least 5 times smaller, and more preferably at least 10 times smaller.

3. The carrier according to claim 1 or 2, wherein the secondary support layer comprises a substrate layer, wherein the substrate layer is made from a second material different from the first material.

4. The carrier according to claim 3, wherein the carrier further comprises an intermediate layer, wherein the substrate layer is connected to the primary support layer through the intermediate layer.

5. The carrier according to claim 4, wherein the intermediate layer comprises an adhesive layer.

6. The carrier according to claim 4, wherein the intermediate layer comprises a body made from the second material, said body comprising a plurality of cavities or recesses that either hold a gaseous medium or are filed with a third material different from the first material.

7. The carrier according to claim 6, wherein the body is integrally connected to the substrate layer.

8. The carrier according to claim 4, wherein the intermediate layer comprises a body made from the first material, said body comprising a plurality of cavities or recesses that hold a gaseous medium and/or are filed with a third material different from the first material, wherein the body is preferably integrally connected to the primary support layer.

9. The carrier according to any of the previous claims, wherein the primary support layer is formed entirely by a single region of the first material.

10. The carrier according to any of the claims 1-8, wherein the one or more regions of the primary support layer comprises mutually separated regions of the first material that are arranged in a body of the second material different from the first material.

11. The carrier according to any of the previous claims, wherein the dynamic release layer comprises a contiguous layer that covers the one or more regions of the primary support layer, wherein the dynamic release layer preferably covers the primary support layer entirely, or
wherein the dynamic release layer comprises a plurality of mutually separated regions, each region of the dynamic release layer directly contacting a respective region of the primary support layer.

12. The carrier according to any of the previous claims, wherein:
the primary support layer has a thickness in a range between 0.01 and 1.0 mm; and/or
the secondary support layer has a thickness in a range between 0.01 and 0.1 mm; and/or
the dynamic release layer has a thickness in a range between 1 and 100 micrometer; and/or
in so far as depending on any of the claims 6-8, the body of the secondary support layer has a thickness in a range between 0.01 and 0.1 mm; and/or
in so far as depending on claim 10, wherein the mutually separated regions of the first material have a thickness in a range between 0.01 and 0.1 mm.

13. The carrier according to any of the previous claims, wherein:
the first material comprises at least one of glass, such as BK7 or quartz, ceramic and siloxane;
and/or
the second material comprises at least one of polyethylene terephthalate, PET, polyethylene naphthalate, PEN, polyimide, PI, and polyvinylchloride, PVC; and/or
the dynamic release layer comprises at least one of molybdenum, aluminum, tin, and indium; and/or
in so far as depending on claim 5, the adhesive layer comprises at least one of epoxy, acrylic and benzocyclobutene; and/or
in so far as depending on claim 6 or 8, the third material comprises at least one of aerogel and siloxane.

14. A wafer assembly, comprising:
The carrier according to any of the previous claims;
a wafer comprising a plurality of mutually separated semiconductor dies, wherein the wafer is arranged on the carrier.

15. A pick-and-place apparatus, comprising:
a first stage comprising a wafer assembly according to claim 14;
a laser source for illuminating the carrier; and
a second stage configured to receive one or more semiconductor dies from the first stage when the carrier is illuminated using the laser source.
